(19)

Europäisches
Patentamt
European
Patent Office
Office européen
des brevets

(11) **EP 3 016 135 A1**

(12) **EUROPEAN PATENT APPLICATION**
published in accordance with Art. 153(4) EPC

(43) Date of publication:
**04.05.2016 Bulletin 2016/18**

(51) Int Cl.:
***H01L 21/52*** *(2006.01)*

(21) Application number: **14817752.0**

(22) Date of filing: **26.06.2014**

(86) International application number:
**PCT/JP2014/067050**

(87) International publication number:
**WO 2014/208690 (31.12.2014 Gazette 2014/53)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **28.06.2013 JP 2013137326**

(71) Applicant: **Furukawa Electric Co., Ltd.
Chiyoda-ku
Tokyo 100-8322 (JP)**

(72) Inventors:
• **SATO, Yoshihiro
Tokyo 100-8322 (JP)**

• **ASADA, Toshiaki
Tokyo 100-8322 (JP)**
• **SATO, Shunichiro
Tokyo 100-8322 (JP)**
• **KOJIMA, Naoyuki
Tokyo 100-8322 (JP)**
• **HIKASA, Kazuhito
Tokyo 100-8322 (JP)**
• **FUJIWARA, Hidemichi
Tokyo 100-8322 (JP)**

(74) Representative: **Schäfer, Matthias W.
Patentanwalt
Schwanseestrasse 43
81549 München (DE)**

(54) **CONNECTION STRUCTURE AND SEMICONDUCTOR DEVICE**

(57)     To provide a connection structure having improved joint life and excellent reliability by preventing generation of cracks or peeling.

Provided is a connection structure in which a object to be connected (C) is joined onto a object to be connected (B) by a porous metal layer (A) which is a connector, in which a porosity of the porous metal layer (A) is from 2 volume% to 38 volume%, the porous metal layer (A) includes an approximately ellipsoidal hole (h), an average circularity of an ellipsoidal shape of the hole (h) in a cross section (V) of the porous metal layer (A) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm.

FIG. 1

**Description**

Technical Field

The present invention relates to a connection structure in which electronic components such as bodies to be connected such as a semiconductor package or a semiconductor chip are joined to each other by forming a porous metal layer using a heat joining material containing fine metal particles and an organic dispersion medium by heating under pressure, and a semiconductor device.

Background Art

In recent years, increase in power, modularization, increase in integration and increase in reliability of a semiconductor component has rapidly proceeded. An operation temperature of a semiconductor tends to be high due to heat generation of a semiconductor product according to an increase in current density for realizing high power and high integration of such a mounting apparatus. In the related art, high-temperature lead solder which withstands usage at a high temperature has been used as a die-bonding material or the like, but the usage of high-temperature lead solder tends to be prevented due to environmental problems. In such circumstances, attention has been paid to joining performed using conductive paste which is obtained by incorporating metal nanoparticles which can realize joining under conditions of a lower temperature than that with a bulk metal object, without using lead, as another die-bonding material which withstands usage at a high temperature.
A method of joining an electronic component (for example, a semiconductor chip) to a substrate by heating and sintering the electronic component using a paste for heating and joining obtained by incorporating metal particles or a plate-like compact under pressure is known. PTL 1 discloses the joining performed using composite metal nano-materials obtained by coating the periphery of fine metal particles with an organic material. In addition, PTL 2 discloses a method of joining copper and metal powder using an adhesive.

Citation List

Patent Literature

    [PTL 1] JP-A-2004-128357
    [PTL 2] JP-A-2000-094341

Summary of Invention

Technical Problem

A heat joining material containing metal particles is disposed between bodies to be connected and heated and pressurized to form a joined part, but a method of mounting an electronic component (for example, a semiconductor chip) by pressurizing and heating the electronic component using a device such as a flip chip bonder or a press is generally used as a joining method. However, it is clear that sufficient reliability is not obtained just by simply joining bodies to be connected using such methods. Particularly, a power semiconductor is used in a severe usage environment, and therefore, a severe reliability test (thermal shock test or power cycle test) is required. It has been found that large differences in results of the reliability test have been obtained depending on a state of a component, even when the bodies to be connected are joined to each other by the methods described above.
A state of a sintered compact may not be constant and it may be difficult to perform joining with excellent reproducibility, just by simply performing the joining as disclosed in PTL 1. Particularly, PTL 1 does not disclose a hole which has an important effect on reliability and it is desired that reliability is further improved here. PTL 2 discloses that a hole is provided in an inner portion, but it is for releasing gas at the time of the joining, and PTL 2 does not disclose that cracks or peeling is prevented and reliability is improved. An object of the invention is to provide a connection structure which alleviates stress generated in a joined part between a porous metal layer and any one or both of bodies to be connected, which is formed when joining two bodies to be connected by the porous metal layer and improves joint life by preventing generation of cracks or peeling, such that it has excellent reliability, and a semiconductor device.

Solution to Problem

The invention is made in view of such circumstances, and the inventors found that the above-mentioned problems are solved by forming approximately ellipsoidal holes in a porous metal layer when joining two bodies to be connected by the porous metal layer which is formed by sintering of a heat joining material, and controlling porosity of holes formed in the porous metal layer, an average circularity of an ellipsoidal shape of the hole in a cross section of the porous metal layer in a thickness direction, a long axis length of an ellipsoidal shape, and an inclination angle of a long axis of an ellipsoidal shape of the hole with respect to the normal to the thickness direction of the cross section, and a connection structure having improved joint life and excellent reliability is obtained, and the inventors completed the invention.

That is, the invention includes inventions disclosed in the following (1) to (6).

(1) A connection structure in which a object to be connected (C) is joined onto a object to be connected (B) by a porous metal layer (A) which is a connector,
in which a porosity of the porous metal layer (A) is from 2 volume% to 38 volume%,
the porous metal layer (A) includes an approximately ellipsoidal hole (h), an average circularity of an ellipsoidal shape of the hole (h) in a cross section (V) of the porous metal layer (A) in a thickness direction is from 0.80 to 0.90, an average value of inclination angles of a long axis of an ellipsoidal shape of the holes (h) with respect to the normal to the thickness direction of the cross section (V) is equal to or smaller than 57 degrees, and an average long axis length of the ellipsoidal shape of the hole (h) in the cross section (V) is from 30 nm to 500 nm (hereinafter, this may be referred to as a first embodiment).
(2) The connection structure according to (1),
in which an average value of inclination angles of the long axis of the ellipsoidal shape of the hole (h) with respect to the normal to the thickness direction of the cross section (V) is from 50 degrees to 57 degrees.
(3) The connection structure according to (1) or (2),
in which a metal forming the porous metal layer (A) is one kind or two or more kinds selected from gold, silver, copper, aluminum, chromium, nickel, titanium, cobalt, and indium.
(4) The connection structure according to any one of (1) to (3),
in which a joined surface part of the object to be connected (B) and the object to be connected (C) with the porous metal layer (A) is formed of one kind or an alloy including two or more kinds selected from gold, silver, copper, chromium, nickel, and titanium.
(5) The connection structure according to any one of (1) to (4),
in which at least a part of the holes (h) formed on the porous metal layer (A) is filled with a heat-resistant resin (R).
(6) A semiconductor device which has a structure in which a circuit board (i) formed of at least a ceramic substrate and a metal circuit formed thereon, a porous metal layer (ii), a conductive layer (iii), a die-bonding joining layer (iv), and a semiconductor element (v) are laminated on each other in this order,
in which a porosity of the porous metal layer (ii) is from 2 volume% to 38 volume%,
the porous metal layer (ii) includes an approximately ellipsoidal hole (h), an average circularity of an ellipsoidal shape of the hole (h) in a cross section (V) of the porous metal layer (ii) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm (hereinafter, this may be referred to as a second embodiment).

Advantageous Effects of Invention

When the heat joining material (M) is disposed between the object to be connected (B) and the object to be connected (C) which is an electronic component and the object to be connected (B) and the object to be connected (C) are joined to each other by performing heating and sintering under pressure, the pressure applied to the heat joining material (M) having a certain viscosity is controlled, and accordingly, it is possible to obtain optimal values of the porosity of the porous metal layer (A) having an approximately ellipsoidal shape, the average circularity of the ellipsoidal shape of the hole (h) in the cross section (V) of the porous metal layer (A) in a thickness direction, the long axis length of the ellipsoidal shape, and the inclination angle of the long axis of the ellipsoidal shape of the hole (h) with respect to the normal to the thickness direction of the cross section (V), improve joint life, maintain heat radiation and conductivity, and perform joining with improved joint life and high reliability.

Brief Description of Drawings

Fig. 1 is a conceptual diagram of a cross section of an ellipsoidal hole in a cross section (V) of a porous metal layer (A) in a thickness direction.

Fig. 2 is a conceptual diagram of a cross section of a sintering furnace used in Examples and Comparative Examples.

Fig. 3 is a graph showing a relationship between "pressure at the time of sintering" and an "average inclination angles of a long axis of an ellipsoidal shape" of connection structures obtained in Examples 1 to 4, 8, and 9 and Comparative Examples 1 to 4.

Fig. 4 is a graph showing a relationship between "pressure at the time of sintering" and an "average circularity" of connection structures obtained in Examples 1 to 4, 8, and 9 and Comparative Examples 1 to 4.

Fig. 5 is a graph showing a relationship between "pressure at the time of sintering" and an "average long axis length of an ellipsoidal shape" of connection structures obtained in Examples 1 to 4, 8, and 9 and Comparative Examples 1 to 4.

Fig. 6 is a graph showing a relationship between the "number of usable times" and an "average inclination angle of a long axis of an ellipsoidal shape" of connection structures obtained in Examples 1 to 4, 8, and 9 and Comparative Examples 1 to 4.

Fig. 7 is a graph showing a relationship between the "number of usable times" and an "average circularity" of connection structures obtained in Examples 1 to 4, 8, and 9 and Comparative Examples 1 to 4.

Fig. 8 is a graph showing a relationship between the "number of usable times" and "porosity" of connection structures obtained in Examples 1 to 4, 8, and 9 and Comparative Examples 1 to 4.

Fig. 9 is a sectional view schematically showing a semiconductor device according to a second embodiment.

Fig. 10 is an explanatory diagram schematically illustrating a method of manufacturing the semiconductor device according to the second embodiment.

Fig. 11 is an explanatory diagram schematically illustrating a method of manufacturing the semiconductor device according to the second embodiment.

Fig. 12 is a photographic image (magnification of 5000) obtained by observing a cross section of a porous metal layer obtained in Example 8 using a scanning electron microscope (SEM).

Description of Embodiments

A [1] connection structure of a first embodiment of the invention and a [2] semiconductor device of a second embodiment which is an applied invention of the first embodiment will be described hereinafter.

Connection Structure (First Embodiment)

[1] Hereinafter, the connection structure of the first embodiment of the invention will be described.

There is provided a connection structure of the first embodiment of the invention in which a object to be connected (C) is joined onto a object to be connected (B) by a porous metal layer (A) which is a connector, in which a porosity of the porous metal layer (A) is from 2 volume% to 38 volume%, the porous metal layer (A) includes an approximately ellipsoidal hole (h), an average circularity of an ellipsoidal shape of the hole (h) in a cross section (V) of the porous metal layer (A) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm.

The connection structure of the invention is a connection structure in which the object to be connected (B) and the object to be connected (C) are joined to each other by the porous metal layer (A), and it can be particularly suitably used in electric and electronic components. Hereinafter, (1) bodies to be connected configuring the connection structure of the invention, (2) the porous metal layer (A), (3) the formation of the porous metal layer (A), and (4) the connection structure will be described.

(1) Bodies To Be Connected

In a case where the connection structure of the invention is an electric or electronic component, one object to be connected (B) can be set as a substrate or the like and the other object to be connected (C) can be set as a semiconductor element or the like, in a case of manufacturing a semiconductor module, as disclosed below, for example. In addition, in a case of manufacturing a ceramic circuit board, one object to be connected (B) can be set as a substrate or the like and the other object to be connected (C) can be set as a metal foil or the like.

(1-1) Substrate

As a substrate (K) used in a semiconductor device, a substrate which is formed by joining a conductive pattern such as a copper plate onto one surface of an insulating layer such as a ceramic by plating, sputtering, or brazing, a direct bonded copper (DBC) substrate obtained by joining an electrode plate to a ceramic substrate, or the like can be suitably used. A copper plate can also be joined to the other surface for heat radiation or the like. A metal plate can be joined to another surface of the substrate (K) for heat radiation or the like. As ceramic, any powdered raw material or two or more kinds of powdered raw material from $Al_2O_3$, AlN, $Si_3N_4$, and glass, or a material prepared by combining a binder component, if necessary, with a powdered raw material containing the above-mentioned materials as main components, molding the combined material into a sheet shape, and sintering the resultant material can be used.

Particularly, $Si_3N_4$ is preferably used because high strength can be expected. A substrate formed of ceramic may be smoothened by suitably grinding a surface with abrasive grains. A thickness of the ceramic substrate can be suitably designed, and is preferably approximately from 100 $\mu$m to 1000 $\mu$m. Particularly, in a case of providing a heat radiation device on a surface of a circuit board on a metal layer side, a thickness of the ceramic substrate may be set to be as small as 100 $\mu$m to 300 $\mu$m, and accordingly it is possible to decrease thermal resistance between a semiconductor element and a heat radiation device. In the invention, a lead frame (L) can also be used in addition to the substrate (K). When the semiconductor element (S) is mounted on the lead frame (L), high heat radiation can be expected.

(1-2) Semiconductor Element (S)

The semiconductor element (S) is an electronic component obtained using a semiconductor or an element of a functional central unit of an electronic component. A semiconductor wafer is produced as an element by firstly cutting (dicing) the semiconductor wafer into a chip unit. After that, the substrate (K) including an electrode for external connection is bonded to the element. In the semiconductor element (S), a metal layer of alloy is generally provided on a surface to which an electrode or the like is joined.

(1-3) Metal Foil

A thickness of a metal circuit layer and a metal layer is preferably from 30 $\mu$m to 500 $\mu$m. It is particularly preferable that the thickness thereof is from 100 $\mu$m to 300 $\mu$m, in order to form the layers on ceramic without wrinkles in manufacturing and decrease thermal stress applied to ceramic when it is used.

As a material thereof, one kind of metal or an alloy of two or more kinds selected from a metal element group having excellent conductivity such as Al, Ag, and Au, in addition to Cu, or an alloy including one or more kinds thereof as main components can be employed, but, particularly, Cu is generally used, because a Cu material having low electrical resistance and various thicknesses can be easily obtained. In addition, Al is conveniently used because electrical resistance is low and Al wire bonding is easily performed.

(2) Porous Metal Layer (A)

In the porous metal layer (A), a porosity is from 2 volume% to 38 volume%, the porous metal layer includes an approximately ellipsoidal hole (h), an average circularity of an ellipsoidal shape of the hole (h) in a cross section (V) of the porous metal layer (A) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm.

The object to be connected (B) and the object to be connected (C) facing each other in the connection structure of the invention are joined to each other using the porous metal layer (A) having a porosity, an average circularity of the hole (h), an average value of inclination angles of a long axis of an ellipsoidal shape, and an average long axis length of the ellipsoidal shape in the specific ranges described above, and accordingly, it is possible to alleviate stress generated in an end portion of a bonded interface between the object to be connected (B) and the porous metal layer (A) and an end portion of a bonded interface between the porous metal layer (A) and the object to be connected (C) to improve joint life, and it is possible to maintain heat radiation and conductivity and improve joining reliability.

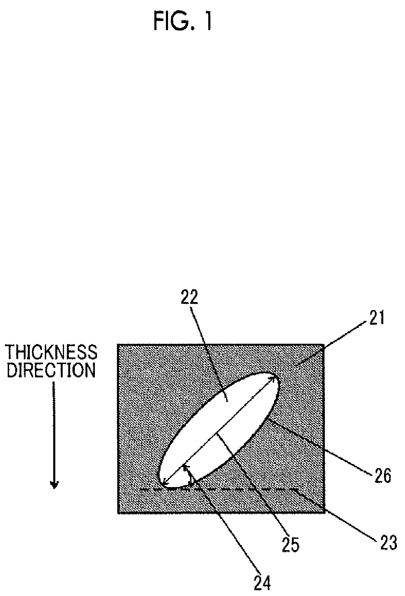

Fig. 1 shows a metal portion 21, a hole (h) 22, a thickness direction 23 of the porous metal layer (A), an average value 24 of inclination angles of a long axis of an ellipsoidal shape, and an average long axis length 25 of an ellipsoidal shape of the porous metal layer (A), respectively. In addition, the approximately ellipsoidal shape disclosed herein means a shape having an ellipsoidal cross section and includes a cylindrical shape, a leaf shape, a fibrous shape, or a shape in which ellipsoidal shapes are interlinked with each other, for example. It can be confirmed that the hole (h) formed in the porous metal layer (A) has an approximately ellipsoidal shape (or ellipsoidal shape) from observation using a scanning electron microscope (SEM).

(2-1) Porosity of Porous Metal Layer (A)

The porosity of the porous metal layer (A) is from 2 volume% to 38 volume%. In the invention, the measurement of the porosity of the porous metal layer (A) can be performed by forming an image of a cross section (V) of the porous metal layer (A) in a thickness direction using a scanning electron microscope (SEM) and performing binarization of the image using image processing software (for example, image processing software "pickmap"). In the binarization, a metal portion derived from fine metal particles (M) contained in the porous metal layer (A) is image-processed to have a white color and the hole thereof is image-processed to have a black color. At this time, variations depending on a measurer are prevented by setting a threshold value of an image having a grayscale with 256 gradations to 80 using image processing software. A porosity of a cross section is calculated from a ratio between white and black areas of the image. The calculation of the porosity per unit volume (volume%) is performed by stereology based on the theory of geometric probability (quantitative morphology). The porosity disclosed hereinafter indicates porosity per volume.

The porosity of the porous metal layer (A) means a "proportion of a volume formed as portions formed of materials other than metal" regarding the metal layer per unit volume, and a volume occupied by a heat-resistant resin (R) other than a metal, an organic dispersion medium (D) remaining after sintering, and the like is included in the "proportion of a volume formed as portions formed of materials other than metal". The cross section (V) of the porous metal layer (A) can be formed by embedding the layer with an embedding resin and cutting and grinding the cross section.

The porosity of the porous metal layer (A) is from 2 volume% to 38 volume% as described above. It is preferable that the porosity is equal to or greater than 2 volume%, in order to effectively exhibit a function of alleviating concentration of stress generated on a bonded interface between the object to be connected (B) and the porous metal layer (A), a bonded interface between the porous metal layer (A) and the object to be connected (C), and the object to be connected (C). Meanwhile, when the porosity is equal to or smaller than 38 volume%, it is possible to ensure a mechanical strength necessary for the porous metal layer (A) and prevent material failure in the porous metal layer (A), and it is possible to ensure strength when a reliability test (power cycle test) is performed. When the porosity exceeds 38 volume%, the strength and conductivity may be decreased.

(2-2) Average Circularity of Ellipsoidal Shape of Hole of Cross Section (V)

The average circularity of the ellipsoidal shape of the hole (h) in the cross section (V) of the porous metal layer (A) in a thickness direction is from 0.80 to 0.90. The average circularity E is defined by the following equation.

$$\text{Circularity E} = 4 \times \text{pi} \times [\text{particle projected area}] / [\text{length of circumference of particle projected image}]^2$$

This average circularity is acquired by performing binarization, in the same manner as in the calculation of the porosity, regarding a SEM image of a cutting surface created in the same manner as in the calculation of the porosity and performing image processing. The image processing, for example, can be performed using image analysis software such as ImageJ of the National Institutes of Health (NIH). When the average circularity is equal to or greater than 0.80, concentration of stress on an end portion of the hole is decreased, it is difficult for cracks to extend further, and reliability is improved. Meanwhile, it is substantially difficult to manufacture a hole having an average circularity of equal to or greater than 0.9, and accordingly, the average circularity is set to be equal to or smaller than 0.9.

(2-3) Average Value of Inclination Angles of Long Axis of Ellipsoidal Shape of Hole (h) of Cross Section (V)

The average value of the inclination angles of the long axis of the ellipsoidal shape of the hole (h) with respect to the normal to the thickness direction of the cross section (V) of the porous metal layer (A) in a thickness direction is equal to or smaller than 57 degrees. As shown in Fig. 1, the inclination angles of the long axis of the ellipsoidal shape are the inclination angles of the long axis of the ellipsoidal shape of the hole (h) with respect to the normal to the thickness direction of the cross section (V) of the porous metal layer (A) in a thickness direction.

The average value of the inclination angles of the long axis of the ellipsoidal shape is acquired by performing binarization, in the same manner as in the calculation of the porosity, regarding a SEM image of a cutting surface created in the same manner as in the calculation of the porosity and performing image processing. The image processing, for example, can be calculated using image analysis software such as ImageJ of the National Institutes of Health (NIH).

The reason that reliability becomes excellent when the average value of the inclination angles of the long axis of the ellipsoidal shape is decreased, may be described with a theory of "concentration of stress on an infinite plate having an ellipsoidal hole". Regarding a material sintered using copper nano paste, a thickness is approximately 150 $\mu$m, a size of a chip is approximately 7 mm x 7 mm, and a ratio between vertical and horizontal lengths is approximately 50 times. Accordingly, by increasing a temperature, the material generally extends in a horizontal direction by thermal expansion. Therefore, thermal stress is applied in an in-plane direction of a copper nano sintered compact.

When considering a case where an ellipsoidal hole exists in the sintered compact in this state and stress is generated in an in-plane direction, a state of stress concentration varies depending on an inclination of the long axis of the ellipsoidal shape. When the inclination thereof is 90 degrees, stress is concentrated on a portion having a small radius of curvature of an ellipse, but when the inclination thereof is 0 degrees, there is no stress concentration. It is also found that a circularity close to 1 indicates that the circle is close to a perfect circle, and accordingly, the stress concentration is decreased. When the average value of the inclination angles of the long axis of the ellipsoidal shape is equal to or smaller than 57 degrees, stress concentration on the end portion of the hole (h) is decreased, crack extension is prevented, and reliability is improved. From such viewpoints, the average value of the inclination angles of the long axis of the ellipsoidal shape is preferably from 50 degrees to 57 degrees.

(2-4) Average Long Axis Length of Ellipsoidal Shape of Hole (h) of Cross Section (V)

The average long axis length of the ellipsoidal shape of the hole (h) in the cross section (V) is from 30 nm to 500 nm. As shown in Fig. 1, the average long axis length 25 of the ellipsoidal shape is an average long axis length of the ellipsoidal shape of the hole (h) in the cross section (V) of the porous metal layer (A) in a thickness direction. The average long axis length of the ellipsoidal shape is acquired by performing binarization, in the same manner as in the calculation of the porosity, regarding a SEM image of a cutting surface created in the same manner as in the calculation of the porosity, and performing image processing. The image processing, for example, can be calculated using image analysis software such as "ImageJ" of the National Institutes of Health (NIH).

The average long axis length of the ellipsoidal shape of the hole (h) is equal to or greater than 30 nm. When the average long axis length is smaller than 30 nm, the sintered compact becomes similar to a bulk body, stress relaxation becomes poor, and reliability is decreased, and accordingly, the average long axis length is desirably equal to or greater than 30 nm. Meanwhile, when the average long axis length of the ellipsoidal shape of the hole (h) exceeds 500 nm, stress is concentrated on a portion of the hole and reliability is decreased, and accordingly, the average long axis length is necessarily equal to or smaller than 500 nm.

(3) Formation of Porous Metal Layer (A)

In the porous metal layer (A), the porosity is from 2 volume% to 38 volume%, the porous metal layer (A) includes the approximately ellipsoidal hole (h), the average circularity of the ellipsoidal shape of the hole (h) in the cross section (V) of the porous metal layer (A) in a thickness direction is from 0.80 to 0.90, the average value of inclination angles of the long axis of the ellipsoidal shape of the hole (h) with respect to the normal to the thickness direction of the cross section (V) is equal to or smaller than 57 degrees, and the average long axis length of the ellipsoidal shape of the hole (h) in the cross section (V) is from 30 nm to 500 nm.

In the porous metal layer (A) of the invention, a heat joining material (M) containing fine metal particles (P) which will be described later and an organic dispersion medium (D) containing one kind of or two or more kinds of polyalcohol including two or more hydroxyl groups in a molecule, is disposed between the bodies to be connected (B) and (C) and the porous metal layer is formed by heating and sintering under pressure. The heat joining material (M) will be described hereinafter.

(3-1) Components of Heat joining material (M)

The heat joining material (M) is a fine metal particles dispersion material in which the fine metal particles (P) are dispersed in the organic dispersion medium (D).

(A) Fine metal Particles (P)

As the fine metal particles (P), only fine metal particles (P1) having sinterability and an average primary particle diameter of 1 nm to 500 nm can be used, but it is preferable that fine metal particles (P1) and fine metal particles (P2) having an average primary particle diameter of 0.5 $\mu$m to 50 $\mu$m are used in combination. Metal species of the fine metal particles are not particularly limited, but it is preferable to use one kind or two or more kinds selected from gold, silver, copper, aluminum, nickel, tin, indium, titanium, platinum, palladium, and silicon.

As the fine metal particles (P) used in the heat joining material (M), at least one kind or more of high-purity fine copper particles can be used as they are, unlike a case of solder paste, and accordingly, it is possible to obtain a joined body having excellent joining strength and conductivity. Generally, in a case of solder paste, a flux (organic component) is contained for removing oxidation of a copper pad portion of a substrate which is a mounting target, and a small amount of metals such as Al, Zn, Cd, or As is contained as impurities contained in metal materials, in many cases.

(i) Fine metal Particles (P1)

The fine metal particles (P1) are not particularly limited, as long as they are fine metal particles having an average particle diameter of primary particles of 1 nm to 500 nm. It is difficult to manufacture fine metal particles (P1) of which the average particle diameter of primary particles is smaller than 1 nm. Meanwhile, when the average particle diameter of the primary particles is equal to or smaller than 500 nm, it is possible to form a dense conductive pattern and sintering is also easily performed. Regarding the average particle diameter of the primary particles, the particles are observed using an electron microscope at a magnification (magnification of 200,000) sufficient for allowing the diameter of one particle to be observed, 20 particles are arbitrarily extracted, and diameters thereof are measured and averaged. Herein, the particle diameter of the primary particles means a diameter of the primary particles which are individual fine metal particles configuring secondary particles.

(ii) Fine metal Particles (P2)

In addition to the fine metal particles (P1) having an average particle diameter of the primary particles of 1 nm to 500 nm, it is preferable that the fine metal particles (P2) having an average particle diameter of the primary particles of 0.5 $\mu$m to 50 $\mu$m are dispersed in the heat joining material (M) and are used. The same kind as the fine metal particles (P1) is preferably used as the fine metal particles used. When the fine metal particles (P2) having an average particle diameter of the primary particles of 0.5 $\mu$m to 50 $\mu$m are used as the fine metal particles (P), in addition to the fine metal particles (P1) having an average particle diameter of the primary particles of 1 nm to 500 nm, as the fine metal particles (P), the fine metal particles (P1) are dispersed among the fine metal particles (P2), it is possible to effectively prevent free movement of the fine metal particles (P1) when performing a heating process and dispersibility and stability of the fine metal particles (P1) are improved. As a result, it is possible to form a porous body having uniform particle diameters and holes (h) by heating and sintering. An average primary particle diameter of the fine metal particles (P2) is preferably from 0.5 $\mu$m to 50 $\mu$m. When the average primary particle diameter of the fine metal particles (P2) is smaller than 0.5 $\mu$m, an effect of addition of the fine metal particles (P2) is not exhibited, and when the average primary particle diameter thereof exceeds 50 $\mu$m, the sintering may be difficult to perform. As a measurement method regarding the fine metal particles (P2), the measurement can be performed using a laser diffraction method. In addition, the average particle diameter was set as a median diameter (diameter ranges on a larger side and a smaller side are the same, when powder particles are divided into two from a point of a certain particle diameter).

A combination ratio of the fine metal particles (P1) and the fine metal particles (P2) in the fine metal particles (P) (mass ratio of [P1/P2]) is from 90/10 to 20/80.

The fine metal particles (P1) play a role of connecting the fine metal particles (P2) to each other, and accordingly, when the amount of the fine metal particles (P1) is small, the strength of the entire porous metal layer is decreased and a point of contact with the chip electrode is made smaller, and therefore, the stress is concentrated on that portion and reliability is decreased. When the proportion of the fine metal particles (P2) exceeds 80%, it is difficult for the porous metal layer to be densely filled, the porosity may exceed 38%, and a probability of generation of large holes may be increased. Thus, reliability is decreased, and therefore, the proportion of the fine metal particles (P2) is desirably equal to or smaller than 80%.

(B) Organic Dispersion Medium (D)

One kind of or two or more kinds of polyalcohol (A1) including two or more hydroxyl groups in a molecule, is contained in the organic dispersion medium (D), but a compound (A2) having an amide group, an amine compound (A3), or a low-boiling-point organic solvent (A4) can be contained, as other organic solvents.

(i) Polyalcohol (A1)

Examples of polyalcohol (A1) include one kind or two or more kinds selected from ethylene glycol, diethylene glycol, 1,2-propanediol, 1,3-propanediol, 1,2-butanediol, 1,3-butanediol, 1,4-butanediol, 2-butene-1,4-diol, 2,3-butanediol, pentanediol, hexanediol, octanediol, glycerol, 1,1,1-trishydroxymethylethane, 2-ethyl-2-hydroxymethyl-1,3-propanediol, 1,2,6-hexanetriol, 1,2,3-hexanetriol, 1,2,4-butanetriol, threitol, erythritol, pentaerythritol, pentitol, 1-propanol, 2-propanol, 2-butanol, 2-methyl 2-propanol, xylitol, ribitol, arabitol, hexitol, mannitol, sorbitol, dulcitol, glycerin aldehyde, dioxy acetone, threose, erythrulose, erythrose, arabinose, ribose, ribulose, xylose, xylulose, lyxose, glucose, fructose, mannose, idose, sorbose, gulose, talose, tagatose, galactose, allose, altrose, lactose, isomaltose, glucoheptose, heptose, maltotriose, lactulose, and trehalose having two or more hydroxyl groups in a molecule. The polyalcohol (A1) has reducibility, and accordingly, when heating and sintering the heat joining material (M), the surface of the fine metal particles (P) is reduced, and when the polyalcohol (A1) is continuously evaporated by further performing a heating process and reduced and sintered in an atmosphere where liquid and vapor thereof exist, the sintering of the fine metal particles (P) is promoted. When considering sinterability of the heat joining material (M), it is preferable that 40 mass% or more of the polyalcohol (A1) is contained in the organic dispersion medium (D).

(ii) Compound Having Amide Group (A2)

Examples of the compound having an amide group (A2) include one kind or two or more kinds selected from N-methylacetamide, N-methylformamide, N-methylpropanamide, formamide, N,N-dimethylacetamide, 1,3-dimethyl-2-imidazolidinone, N,N-dimethylformamide, 1-methyl-2-pyrrolidone, hexamethylphosphoric triamide, 2-pyrrolidinone, ε-caprolactam, and acetamide. The compound having an amide group (A2) can be incorporated so that the amounts thereof is from 10 mass% to 80 mass% in the organic dispersion medium (D).

(iii) Amine Compound (A3)

Examples of the amine compound (A3) include one kind or two or more kinds of amine compound selected from aliphatic primary amines, aliphatic secondary amines, aliphatic tertiary amines, aliphatic unsaturated amines, cycloaliphatic amines, aromatic amines, and alkanolamines. Specific examples thereof include one kind or two or more kinds selected from methylamine, dimethylamine, trimethylamine, ethylamine, diethylamine, triethylamine, n-propylamine, di-n-propylamine, tri-n-propylamine, n-butylamine, di-n-butylamine, tri-n-butylamine, t-propylamine, t-butylamine, ethylenediamine, propylenediamine, tetramethylenediamine, tetramethylpropylenediamine, pentamethyldiethylenetriamine, mono-n-octylamine, mono-2-ethylhexylamine, di-n-octylamine, di-2-ethylhexylamine, tri-n-octylamine, tri-2-ethylhexylamine, triisobutylamine, trihexylamine, tri-iso-octylamine, tri-iso-nonylamine, triphenylamine, dimethyl coconut amine, dimethyloctylamine, dimethyldecylamine, dimethyllaurylamine, dimethylmyristylamine, dimethylpalmitylamine, dimethylstearylamine, dimethylbehenylamine, dilaurylmonomethylamine, diisopropylethylamine, methanolamine, dimethanolamine, tri-methanolamine, ethanolamine, diethanolamine, triethanolamine, propanolamine, isopropanolamine, diisopropanolamine, triisopropanolamine, butanolamine, N-methylethanolamine, N-methyldiethanolamine, N,N-dimethylethanolamine, N-ethylethanolamine, N-ethyldiethanolamine, N,N-diethylethanolamine, N,n-butylethanolamine, N-n-butyldiethanolamine, and 2-(2-amino ethoxy)ethanol. The amine compound (A3) can be incorporated so that the amount thereof is from 0.3 mass% to 30 mass% in the organic dispersion medium (D).

(iv) Organic Solvent (A4)

The organic solvent (A4) is an organic solvent in which a boiling point at standard pressure is from 60°C to 120°C (hereinafter, a boiling point is a boiling point at ordinary pressure) which is a comparatively low boiling point. As the organic solvent (A4), one kind or two or more kinds selected from alcohols, ethers, and ketones having one hydroxyl group in a molecule are preferable. Examples of alcohols having one hydroxyl group in a molecule include one kind or two or more kinds selected from methanol (64.7°C), ethanol (78.0°C), 1-propanol (97.15°C), 2-propanol (82.4°C), 2-butanol (100°C), and 2-methyl 2-propanol (83°C). Examples of ethers include one kind or two or more kinds selected from diethyl ether (35°C), methyl propyl ether (31°C), dipropyl ether (89°C), diisopropyl ether (68°C), methyl-t-butyl ether (55.3°C), t-amylmethyl ether (85°C), divinyl ether (28.5°C), ethyl vinyl ether (36°C), and allyl ether (94°C). In addition, examples of ketones include one kind or two or more kinds selected from acetone (56.5°C), methyl ethyl ketone (79.5°C), and diethyl ketone (100°C). The temperatures in the parentheses are boiling points.

Since the organic solvent (A4) which is a low-boiling-point organic solvent is contained in the organic dispersion medium (D), it is possible to adjust the viscosity of the organic dispersion medium (D) and improve precision of pattern formation. The organic solvent can be incorporated so that a content ratio of the organic solvent (A4) in the organic dispersion medium (D) is approximately from 1 mass% to 30 mass%.

(3-2) Heat joining material (M)

The heat joining material (M) of the invention is a joining material in which the fine metal particles (P) are dispersed in the organic dispersion medium (D). A ratio of the fine metal particles (P) in the heat joining material (M) is more preferably from 40 mass% to 90 mass%, when considering coating properties or sheet moldability. When the heat joining material (M) is manufactured with such a combination ratio, a viscosity of the heat joining material (M) is from 10 Pa·s to 100 Pa·s and a joining material having excellent joining properties is obtained. The viscosity of the heat joining material (M) can be measured rotating a spindle 10 times using a DV-III Ultra manufactured by Brookfield Engineering. The heat joining material (M) of the invention can be set as a joining material having a sheet shape at room temperature or a heating joining paste-like material in which the fine metal particles (P) are dispersed in the organic dispersion medium (D). The heat joining material (M) can be acquired by dispersing the fine metal particles (P) in the organic dispersion medium (D) using a well-known mixer or kneading machine. In the heat joining material (M), high-purity fine metal particles (P) not containing impurities which are contained in solder paste can be used, and accordingly, it is possible to improve joining strength and conductivity.

(4) Connection Structure

The connection structure of the invention is formed by disposing a patterned material formed of the heat joining material (M) on the object to be connected (B) (for example, a surface of a ceramic plate), further disposing the object to be connected (C) on the patterned material, and heating the materials in a range of temperatures at which the fine metal particles (P) are sintered. At the time of heating, the polyalcohol (A1) causes reduction and activation of the surface of the fine metal particles (P) and the sintering between the fine metal particles (P) is prompted. As a result, it is possible to electrically and mechanically join the electrode and substrate, in the same manner as in a case of using paste containing nano-sized fine metal particles. In addition, the organic dispersion medium (D) is removed by decomposition and evaporation, when heating and sintering the heat joining material (M).

When sintering the heat joining material (M), the heat joining material (M) is disposed on a surface of a joined part of the object to be connected (B), for example, the object to be connected (C) is further disposed on a surface of a joined part of the disposed heat joining material (M), the materials are introduced to a device which can press the materials in a vacuum state. In a case of the paste-like heat joining material (M), this process can be performed using a coating or printing method. After that, the materials are interposed between pressing plates with a heater embedded therein, thinning is performed and pressure is sufficiently reduced. Since a pressure of the atmospheric pressure is applied at that time, a pressure is applied by oil pressure or air pressure while taking this into consideration.

When a pressure is smaller than 5 MPa, holes are not sufficiently closed and a hole having a large size may exist. The reason thereof is not sufficiently clear, but it is considered that holes are closed due to the pressure and the shape thereof becoming close to a perfect circle so that a surface energy becomes a minimum. Accordingly, when a pressure applied is low, a large number of particles having a circularity equal to or smaller than 0.8 are obtained. At the time of pressurization, the inclination angle of the long axis of the ellipse is decreased which allows the paste to flow in a horizontal direction. Accordingly, when the pressure applied is low, a large number of holes (h) having a large average inclination angle of the long axis of the ellipsoidal shape of the hole (h) in the cross section (V) are obtained, and accordingly, the pressure is preferably from 5 MPa to 20 MPa.

Therefore, by performing heating and sintering in a state where the object to be connected (B), the heat joining material (M), and the object to be connected (C) come into contact with each other, the fine metal particles (P) in the heat joining material (M) are sintered, the porous metal layer (A) which is porous is formed, and thus, the object to be connected (B) and the object to be connected (C) are joined with each other by the porous metal layer (A). When the heating and sintering temperature reaches approximately 190°C to 350°C, it is preferable that the materials are held for approximately 5 minutes to 120 minutes.

Then, after elapse of a predetermined time at a predetermined temperature in a state where the heating of the heater plate is maintained, pressing is stopped and a sample is removed. A thickness of the porous metal layer (A) formed by this method is preferably approximately from 5 $\mu$m to 500 $\mu$m. When the thickness thereof is smaller than 5 $\mu$m and a component generating great heat (power device) is mounted on the object to be connected (B) such as a conductive metal plate, thermal resistance when heat generated from the component is applied to a metal plate below is decreased, but joining reliability may be decreased. Meanwhile, when the thickness thereof exceeds 500 $\mu$m, thermal resistance may be increased. By employing the sintering conditions described above, in the porous metal layer (A), the porosity can be set to be from 2 volume% to 38 volume%, the average circularity of the ellipsoidal shape of the hole (h) can be set to be from 0.80 to 0.90, the average long axis length can be set to be from 30 nm to 500 nm, and the average value of inclination angles of the long axis of the ellipsoidal shape can be set to be equal to or smaller than 57 degrees.

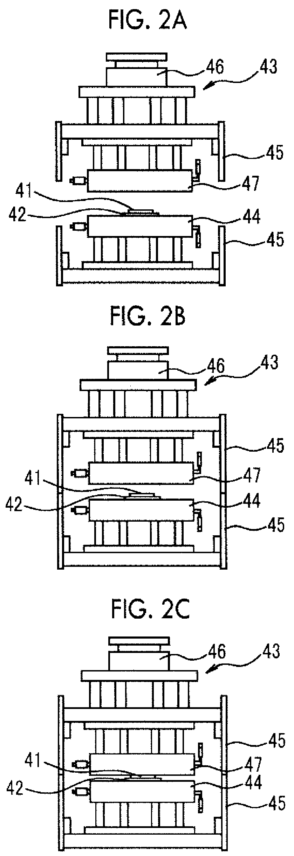

In the heating and sintering, for example, the heat joining material (M) is sintered by the following operations using a sintering apparatus shown in Fig. 2 and a connection structure can be formed.

A pressing plate 42 for lay-up shown in Fig. 2(a) is prepared; a workpiece 41 being laid on the pressing plate 42 and set on a lower heating platen 44 of a vacuum pressing machine 43. Then, as shown in Fig. 2(b), a chamber 45 is closed and the inner portion of the chamber 45 is brought into a vacuum state. As shown in Fig. 2(c), the workpiece 41 is interposed between an upper heating platen 47 and the lower heating platen 44 and heated in a state where pressure is applied by a pressurizing cylinder 46. Accordingly, the heat joining material (M) is sintered, a porous metal layer is formed, and it is possible to manufacture a connection structure in which the object to be connected (C) is joined onto the object to be connected (B) by the porous metal layer (A).

When forming the porous metal layer (A) of the invention, when sintering is performed by heating from a side above the object to be connected (C) by further combining the heat-resistant resin (R) with the heat joining material (M), the heat-resistant resin (R) is extruded to an outer circumference side with the organic dispersion medium (D), at least a part of a surface of an outer circumference side of the porous metal layer (A) and/or the object to be connected (C) is covered with a coating layer formed of the heat-resistant resin (R), and accordingly, the attachment of fine metal particles to the side surface of the object to be connected (C) is prevented and it is possible to obtain a semiconductor device having excellent characteristics. In addition, by combining the heat-resistant resin (R) with the heat joining material (M), the porous metal layer (A) filled with the heat-resistant resin (R) can be formed on at least a part of the holes (h) formed in the porous metal layer (A).

As a component for forming the heat-resistant resin (R), a prepolymer solution or a resin solution is used. Examples of a prepolymer solution component include a solution of an epoxy resin having two or more epoxy groups in one molecule, and a polyimide prepolymer solution. Examples of the resin solution include resins such as a silicon resin, an amideimide resin, a maleimide resin, and a polyvinyl pyrrolidone. In the heat-resistant resin (R), it is preferable that a load deflection temperature is equal to or higher than 150°C and a glass transition temperature (Tg) is equal to or higher than 100°C.

[2] Semiconductor Device (Second Embodiment)

A "semiconductor device" of a second embodiment of the invention is an invention using the "connection structure" of the first embodiment. Hereinafter, the semiconductor device of the second embodiment and a manufacturing method thereof will be described.

[2-1] Semiconductor Device

There is provided a semiconductor device of the second embodiment having a structure in which at least a circuit board (i) which is formed of at least a ceramic substrate and a metal circuit formed thereon, a porous metal layer (ii), a conductive layer (iii), a die-bonding joining layer (iv), and a semiconductor element (v) are laminated on each other in this order, in which a porosity of the porous metal layer (ii) is from 2 volume% to 38 volume%, the porous metal layer (ii) includes an approximately ellipsoidal hole (h), an average circularity of an ellipsoidal shape of the hole (h) in a cross section (V) of the porous metal layer (ii) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm.

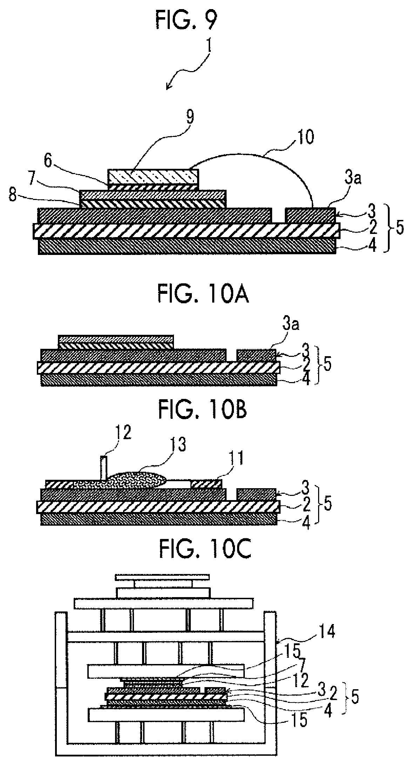

As shown in Fig. 9, in the semiconductor device 1, a semiconductor element (v) 9 is further joined onto a conductive layer (iii) 7 of an "electronic circuit board including a ceramic substrate 2, a metal circuit layer 3 which is formed on one surface side of the ceramic substrate 2, a porous metal layer (ii) 8 which is formed on the metal circuit layer 3 and is formed of a sintered compact of metal particles, and the conductive layer (iii) 7 which is formed on the porous metal layer (ii) 8 and in which an area of a surface facing the metal circuit layer 3 is smaller than that of the metal circuit layer 3" by a die-bonding joining layer (iv) 6.

The "semiconductor device" of the second embodiment will be specifically described below with reference to the drawings.

As shown in Fig. 9, the semiconductor device 1 according to the embodiment includes a circuit board (i) 5 including the ceramic substrate 2, the metal circuit layer 3 (corresponding to the object to be connected (B) of the first embodiment) which is formed on one surface of the ceramic substrate 2, and a metal layer 4 for thermal diffusion and warp prevention which is formed on the other surface of the ceramic substrate 2. The porous metal layer (ii) 8 (corresponding to the porous metal layer (A) of the first embodiment) which is formed of a sintered compact of metal particles is provided on the upper surface of the metal circuit layer 3 of the circuit board (i) 5, and the conductive layer (iii) 7 (corresponding to the object to be connected (C) of the first embodiment) is provided on the porous metal layer (ii) 8. The area of the surface of the conductive layer (iii) 7 facing the metal circuit layer 3 is smaller than that of the metal circuit layer 3. The semiconductor element (v) 9 is joined to the conductive layer (iii) 7 by the die-bonding joining layer (iv) 6. A terminal (not shown) formed on the upper surface (surface on a side which is not joined to the die-bonding joining layer (iv) 6) of the semiconductor element (v) 9 and a wiring 3a of the circuit board 5 are connected to each other using a wire 10.

Hereinafter, each layer of the semiconductor device 1 according to the second embodiment will be described in detail.

(1) Circuit Board (i)

As the circuit board (i) 5 of the second embodiment, a DBC substrate in which a copper circuit plate as the metal circuit layer 3 and a copper plate as the metal layer 4 are respectively joined onto the ceramic substrate 2 by eutectic reaction can be used. As the ceramic substrate 2, any powdered raw material or two or more kinds of powdered raw materials of $Al_2O_3$, AlN, $Si_3N_4$, and glass, or a material prepared by combining a binder component, if necessary, with a powdered raw material containing the above-mentioned materials as main components, molding the combined material into a sheet shape, and sintering the resultant material can be used. Particularly, $Si_3N_4$ is preferably used because then high strength can be expected. A substrate formed of a ceramic may be smoothened by suitably grinding a surface with abrasive grains.

A thickness of the ceramic substrate 2 can be suitably designed, and is preferably approximately from 100 $\mu$m to 1000 $\mu$m. Particularly, in a case of providing a heat radiation device on a surface of a circuit board (i) 5 on the metal layer 4 side, a thickness of the ceramic substrate 2 may be set to be as small as 100 $\mu$m to 300 $\mu$m, and accordingly it is possible to decrease a thermal resistance between a semiconductor element 9 and a heat radiation device. A thickness of the metal circuit layer 3 and the metal layer 4 is preferably from 30 $\mu$m to 500 $\mu$m. It is particularly preferable that the thickness thereof is from 100 $\mu$m to 300 $\mu$m, in order to form the layers on ceramic without wrinkles in manufacturing and decrease thermal stress applied to ceramic when it is used.

In the second embodiment, a DBC substrate can be used as the circuit board 5, but there is no limitation. As a material of the metal circuit layer 3 and the metal layer 4, one kind of metal or an alloy of two or more kinds selected from a metal element group having excellent conductivity such as Al, Ag, and Au, in addition to Cu, or an alloy having one or more kinds thereof as main components can be employed, but, particularly, Cu is generally used, because a Cu material having low electrical resistance and various thicknesses can be easily obtained. In addition, Al is conveniently used because electrical resistance is low and Al wire bonding is easily performed. Further, a substrate in which the metal circuit layer 3 or the metal layer 4 is joined onto the ceramic substrate 2 through brazing filler metal to which an active metal such as Ti or Zr is added may be used.

In addition, a substrate in which the metal circuit layer 3 or the metal layer 4 is laminated on the ceramic substrate 2 with a ground layer may be used. The ground layer is formed from a metal material, an organic material, or a material obtained by mixing a metal material and an organic material. As the metal material, Ti, Cr, Cu, Ni, Ag, or Au can be suitably used. As the organic material, a material such as a polyamide, epoxy, polyimide, or polyalcohol, or general materials obtained by applying substitution plating properties and photosensitivity to the above materials can be suitably used. As the material obtained by mixing a metal material and an organic material, a material obtained by mixing the metal material and the organic material at an arbitrary ratio can be suitably used. The same material as used for the porous metal layer (ii) 8 which will be described later is evenly supplied to the ceramic substrate 2, and subjected to sintering or plasma treatment in an inert or reducing atmosphere, and a resultant material can be used as the ground layer. By performing the plasma treatment, it is possible to shorten the formation time from that used in general heating. A thickness of the ground layer can be suitably designed, but is preferably from 0.01 $\mu$m to 5 $\mu$m.

In the second embodiment, the ceramic substrate 2 is used as the substrate, but instead of this, a substrate formed of an organic material may be used. As the organic material, a material such as a polyamide, epoxy, or polyimide, or general materials obtained by applying substitution plating properties and photosensitivity to the above materials can be suitably used. The usable material is not limited thereto and any material can be used as long as it is suitable for the object of the invention.

(2) Porous Metal Layer (ii)

As described above, the porous metal layer (ii) includes an approximately ellipsoidal hole (h), a porosity is from 2 volume% to 38 volume%, an average circularity of an ellipsoidal shape of the hole (h) in a cross section (V) of the porous metal layer (ii) in a thickness direction is from 0.80 to 0.90, an average value of inclination angles of a long axis of an ellipsoidal shape of the hole (h) with respect to the normal to the thickness direction of the cross section (V) is equal to or smaller than 57 degrees, and an average long axis length of the ellipsoidal shape of the hole (h) in the cross section (V) is from 30 nm to 500 nm.

The average circularity of the ellipsoidal shape of the hole (h), the average value of the inclination angles of the long axis of the ellipsoidal shape of the hole (h), and the average long axis length of the ellipsoidal shape of the hole (h) of the porous metal layer (ii) are the same as those disclosed regarding the "porous metal layer (A)" of the first embodiment. In addition, the approximately ellipsoidal shape disclosed herein means a shape having an ellipsoidal cross section and includes a cylindrical shape, a leaf shape, a fibrous shape, or a shape in which ellipsoidal shapes are interlinked with each other, for example.

The porous metal layer (ii) is a layer formed by sintering the heat joining material (M) under pressure, and the fine metal particles (P) used in the heat joining material (M) preferably includes any one kind or two or more kinds of metal selected from gold, silver, copper, aluminum, nickel, tin, indium, titanium, platinum, palladium, and silicon as main constituent elements. Cu is particularly preferable, because it can prevent migration. In addition, when the material of the fine metal particles is set as the same material as the metal circuit layer 3 or the conductive layer (iii) 7, joining is easily performed. Regarding the fact that it is preferable to use fine metal particles (P2) having an average particle diameter of the primary particles of 0.5 $\mu$m to 50 $\mu$m in addition to fine metal particles (P1) having an average particle diameter of the primary particles of 1 nm to 500 nm, as the fine metal particles (P) used, as the fine metal particles (P), the preferable materials, average primary particle diameter, and each usage proportion of the fine metal particles (P1) and the fine metal particles (P2) are the same as disclosed regarding the "porous metal layer (A)" of the first embodiment. In addition, by combining the heat-resistant resin (R) with the heat joining material (M), the porous metal layer (ii) filled with the heat-resistant resin (R) can be formed on at least a part of the holes (h) formed in the porous metal layer (ii). The components for forming the heat-resistant resin (R) are the same as disclosed regarding the "porous metal layer (A)" of the first embodiment.

A thickness of the porous metal layer (ii) 8 is preferably from 5 $\mu$m to 500 $\mu$m. When the thickness thereof is smaller than 5 $\mu$m, a crystal size of the circuit layer is great, and accordingly, a surface becomes rough and local voids may be generated. When the thickness thereof exceeds 500 $\mu$m, variation in a supplied thickness also becomes great and connection irregularity occurs. The thickness thereof is particularly preferably from 10 $\mu$m to 300 $\mu$m, in order to realize reliable connection. By providing the porous metal layer (ii) 8, it is possible to absorb stress when the metal material configuring the porous metal layer (ii) 8 is extended due to heat or when stress due to a difference in coefficients of linear expansion between the ceramic substrate 2, the metal circuit layer 3, and the conductive layer (iii) 7 is generated, and accordingly, stress applied to the end portion of the metal circuit layer 3 is alleviated. In addition, thermal resistance is decreased and heat radiation is excellent due to joining of the metal circuit layer 3 and the conductive layer (iii) by the porous metal layer (ii) 8.

(3) Conductive Layer (iii)

The conductive layer (iii) 7 is preferably formed of one kind of metal or an alloy of two or more kinds selected from a metal element group consisting of Cu, Al, Ag, and Au, or an alloy having one or more kinds thereof as main components, and it is particularly preferable that the conductive layer is formed of the same material as that of the porous metal layer (ii) 8, from a viewpoint of thermal stress generated in a sintered compact layer due to differences in heat radiation or linear expansion.

(4) Die-Bonding Joining Layer (iv)

As the die-bonding joining layer (iv) 6, the same sintered compact of the metal particles as that of the porous metal layer (ii) 8 described above in which a melting point after the sintering is equal to or higher than 250°C can be used. A sintered compact of fine copper particles is particularly preferable, from a viewpoint of joining properties with respect to the conductive layer (iii) 7. By connecting the conductive layer (iii) 7 and the semiconductor element (v) 9 by the sintered compact of the fine metal particles, absorption is performed by holes, even when the metal configuring the conductive layer (iii) 7 is expanded due to heat, and accordingly, elasticity modulus is decreased on appearance. In addition, even when stress due to a difference in coefficients of linear expansion between the semiconductor element (v) 9, the circuit board (i) 5, and the conductive layer (iii) 7 is generated, it is absorbed by the holes, and accordingly, stress is alleviated. Therefore, it is possible to reduce peeling or cracks generated between the semiconductor element (v) 9 and the conductive layer (iii) 7. The die-bonding joining layer (iv) 6 is not limited to the sintered compact of metal particles, and brazing filler metal (solder) having a melting point equal to or higher than 250°C may be used.

(5) Semiconductor Element (v)

For the semiconductor element (v) 9, Si, SiC, GaN, or GaAs can be used and SiC which radiates heat excellently is particularly preferable.

[2-2] Manufacturing Method of Semiconductor Device

The manufacturing method of the semiconductor device 1 according to the second embodiment will be described.

As shown in Fig. 10(A), the circuit board (i) 5 in which the metal circuit layer 3 is joined to the upper surface of the ceramic substrate 2 and the metal layer 4 is joined to the lower surface thereof is prepared. Next, as shown in Fig. 10(B), a mask 11 including an opening area having a size corresponding to a size of the conductive layer (iii) 7 is disposed at a position corresponding to a position for mounting the semiconductor element (v) 9 on the metal circuit layer 3, and a paste 13 which is the heat joining material (M) in which the fine metal particles (P) are dispersed in the organic dispersion medium (D) is printed using a squeegee 12. For the mask 11, a metal mask such as stainless steel can be used. The squeegee 12 is preferably made of metal, and when it is made of rubber, it is preferable to use a material having high hardness, because deformation of an opening area of the mask 11 due to printing pressure is prevented, and accordingly, a supplied amount of the paste is easily controlled. After the printing, the material is dried in the atmosphere.

In the second embodiment, the paste 13 as the heat joining material (M) can be applied onto the metal circuit layer 3 by printing, but there is no limitation thereto, and the paste can be applied thereto by a dispenser and paste 13 which has previously been formed into a sheet shape and in which the fine metal particles (P) are dispersed in the organic dispersion medium (D) can also be disposed at a predetermined position in the metal circuit layer 3. As a method of previously forming the paste 13 into a sheet shape, a method disclosed in JP-A-2013-041895 can be used.

After that, as shown in Fig. 10(C), the conductive layer (iii) 7 is disposed on the paste 13, pressurized and heated in the atmosphere at a reduced pressure using a vacuum pressing machine 14 to form the porous metal layer (A), and accordingly, joining is performed. The conditions at that time are set as a temperature of 190°C to 350°C, a pressure of 5 MPa to 20 MPa, and a time of approximately 5 minutes to 120 minutes, but a longer period of time is preferable. The atmosphere may be an inert atmosphere or a reducing atmosphere. At this time, the lower surface of the circuit board 5 and the upper surface of the conductive layer (iii) 7 are evenly pressurized. In addition, an additional material 15 may be disposed in order to prevent deformation due to local pressure applied to a pressing platen or attachment of organic materials such as the organic dispersion medium (D). As the additional material 15, a material having heat resistance, for example, a polyimide film or a crystal polymer, a sheet formed of a resin material such as Teflon (registered trademark) sheet, or a sheet formed of a metal material such as copper foil or SUS can be used. When it is easy to follow a change in volume of the sintered compact at the time of pressurization, it is possible to decrease variation or unevenness in pressure in a product or between products, and accordingly, it is preferable to use a Teflon sheet.

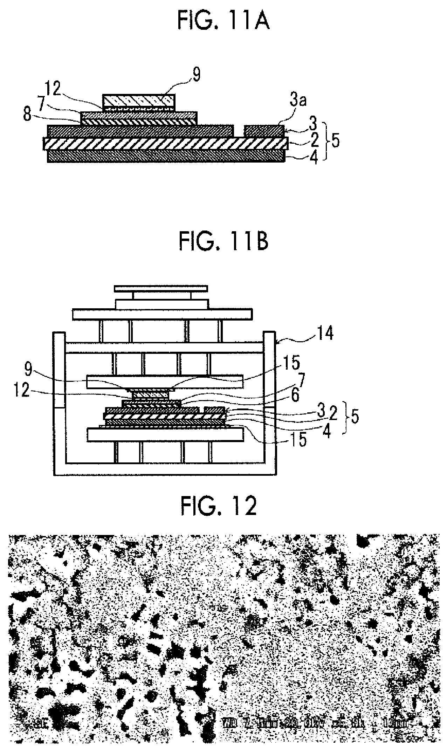

Next, as shown in Fig. 11(A), the paste 13 is supplied to a position corresponding to a position for mounting the semiconductor element (v) 9 on the conductive layer (iii) 7 and dried, and the semiconductor element (v) 9 is disposed thereon. As a supplying method and a drying method, the same methods as the supplying and drying methods of the paste 13 on the metal circuit layer 3 described above can be used. After that, as shown in Fig. 11(B), a structure in which the paste and the semiconductor element (v) 9 are disposed on the conductive layer (iii) 7 which is provided on the circuit board 5 by the porous metal layer (ii) 8, is pressurized and heated in the atmosphere at a reduced pressure using the vacuum pressing machine 14, and the semiconductor element (v) 9 and the conductive layer (iii) 7 are joined to each other by the die-bonding joining layer (iv) 6 (in the embodiment, as the die-bonding joining layer, a sintered compact of the paste 13 in which metal particles are dispersed in an organic dispersion medium can be used). The conditions at this time are set as a temperature of 300°C to 350°C, a pressure of 5 MPa to 20 MPa, and a time of approximately 5 minutes to 120 minutes, but a longer period of time is preferable. The atmosphere may be an inert atmosphere or a reducing atmosphere. At this time, the additional material 15 may be disposed on the lower surface of the circuit board (i) 5 and the upper surface of the semiconductor element (v) 9. When using solder as the die-bonding joining layer (iv) 6, instead of the sintered compact of metal particles, a reflowing device can be used.

Then, a terminal (not shown) formed on the upper surface (surface on a side which is not joined to the die-bonding joining layer (iv) 6) of the semiconductor element (v) 9 and the wiring 3a of the circuit board (i) 5 are connected to each other by wire bonding using the wire 10, and the semiconductor device 1 is manufactured. In the second embodiment, a DBC substrate is used as the circuit board (i) 5 and porous metal layer (ii) 8, the conductive layer (iii) 7, the die-bonding joining layer (iv) 6, and the semiconductor element (v) 9 can be mounted on the DBC substrate, but a DBC substrate on which the porous metal layer (ii) 8 and the conductive layer (iii) 7 are formed may be manufactured in advance, and the semiconductor element (v) 9 can be mounted on this substrate by using this as the circuit board, by the die-bonding joining layer (iv) 6.

Examples

The invention will be described more specifically using Examples. The invention is not limited to Examples.

Examples 1 to 9 and Comparative Examples 1 to 5 according to the first embodiment show a case where a ceramic circuit board and a semiconductor element are joined to each other by sintering using a heat joining material, and as a method of evaluation thereof, evaluation was performed in a thermal stress test by heating the semiconductor element.

Examples 10 to 14 and Comparative Examples 6 and 7 according to the second embodiment show a case where metal foil is further joined to the entirety or a part of a ceramic circuit board on which a metal circuit had previously been formed when manufacturing a ceramic circuit board using a heat joined body, and as a method of evaluation thereof, a cold impact test and evaluation of heat radiation were employed.

[1] Examples 1 to 9 and Comparative Examples 1 to 5

Hereinafter, materials, evaluation methods, and examples used in Examples 1 to 9 and Comparative Examples 1 to 5 according to the first embodiment, and results of evaluation thereof will be described.

(1) Materials Used

(1-1) Preparation of Heat joining material

The following fine copper particles (P1) and fine copper particles (P2) were combined with each other at a mass ratio shown in Tables 1 and 2. The fine copper particles were combined so that a proportion of the fine metal particles (P) in the entire heat joining material became 40 mass%, using glycerin and N-methylacetamide as an organic dispersion medium. Specifically, fine copper particles (P1) having an average primary particle of 50 nm and fine copper particles (P2) having an average primary particle diameter of 4.3 $\mu$m were combined with 120 g of the organic dispersion medium formed of 108 g of glycerin and 12 g of n-methylacetamide so that the total amount of fine copper particles becomes 80 g at a ratio shown in Table 1. A heat joining material was obtained by sufficiently mixing the materials with a mortar and pestle. The obtained heat joining material was printed to have a larger size than an electronic component to be joined using a metal mask having a thickness of 100 $\mu$m and a squeegee. Then, the material was dried in an oven at 110°C in the atmosphere, in order to evaporate a solvent and adjust a concentration of metal.

(1-2) Substrate (Object To Be Connected (B)) and Electronic Component (Object To Be Connected (C))

(i) Substrate

As a substrate, a substrate (model number: KO-PER110681 manufactured by Kyocera Corporation) in which copper foil having a thickness of 320 $\mu$m is attached to a surface of a silicon nitride substrate having a thickness of 320 $\mu$m and copper foil having a thickness of 200 $\mu$m is attached to a surface opposite thereto was used.

(ii) Semiconductor Element

The semiconductor element was a silicon chip having a size of 7.2 mm x 7.2 mm x 0.4 (thickness) mm. As the silicon substrate, an n-type material in which a Ti/Al electrode was formed on one surface of the silicon chip and a layer having a thickness of Ti/Ni/Au = 100/450/200 nm was formed by a sputtering method on a surface on the opposite side thereto, was used.

(iii) Mounting Method

"Manufacturing Method of Semiconductor Device"

A metal mask including an opening area having a size of 8 mm x 8 mm and having a thickness of 100 $\mu$m was prepared. The material was printed on the substrate using this metal mask and a squeegee. Then, the material was dried in an oven at 110°C in the atmosphere for 30 minutes, in order to evaporate a solvent. The joining was performed by a method shown in processes of the "manufacturing method of the semiconductor device" described above. The joining conditions were set as a temperature of 300°C and a period of time of 20 minutes in the atmosphere at a reduced pressure (a pressure was as shown in Tables 1 and 2). In addition, Teflon was used as the additional material 15 shown in Fig. 11.

(2) Evaluation Methods

(2-1) Evaluation of Reliability

10 wires having a thickness of 0.3 mm were mounted on a manufactured silicon chip-mounted sample. Then, the silicon chip-mounted sample was fixed to a copper plate having a thickness of 3 mm and a size of 40 mm x 50 mm by joining using solder with 90 mass% of lead and 10 mass% of tin. An applied voltage was set and heating was performed so that a temperature of only a chip portion was increased to 220°C for 1 second by applying a current to this sample, and cooling was performed for 9 seconds, and accordingly, thermal stress was applied to the joined part. This test was repeated with a constant applied voltage being set. When thermal stress is applied, cracks are generated on a joined part and heat resistance increases. When a percentage increase in heat resistance is 20%, this was determined as failure, and the "number of usable times" until failure was measured.

(2-2) Evaluation Method of Cross Section of Porous Metal Layer

A cross section of the porous metal layer was formed by embedding a sample with an embedding resin and cutting and grinding the cross section. Then, the cross section was formed using an Ar beam by a cross section polisher (SM-09010 manufactured by JEOL Ltd.). An accelerating voltage of the Ar beam was set as 4.6 kV and a degree of vacuum was set to be equal to or smaller than $1 \times 10^{-3}$ Pa. Then, the cross section was observed using a SEM (SEMEDX Type N manufactured by Hitachi High-Tech Group). An accelerating voltage was set as 20 kV and a secondary electron image was observed. An image for analysis having a size of 25.6 $\mu$m $\times$ 11.1 $\mu$m was cut from the obtained SEM image (5000 magnification) so that a part which disturbs analysis such as information regarding an acceleration voltage was not included. Regarding a procedure, the image processing software "ImageJ" (National Institutes of Health (NIH)) was used, an image was read, a necessary region was selected and cut in a procedure of "Image" → "Crop", and an image was stored.

Using the image processing software "pickmap", the binarization of the stored image was performed using one of functions of "pickmap" "tools (tool for binarizing and calculating black/white areas)". A metal portion derived from fine metal particles (M) contained in the porous metal layer (A) was image-processed to have a white color and the holes thereof were image-processed to have a black color. At this time, a threshold value was set as 80. The porosity was acquired from a ratio between white and black areas of the cross section (size of 25.6 $\mu$m $\times$ 11.1 $\mu$m). The porosity per volume was acquired from the porosity of the cross section by stereology. After that, the calculation of the circularity, the inclination angle of the long axis of the ellipse, and the average long axis length was performed by the image analysis software "ImageJ" (National Institutes of Health (NIH)). Area, Fit ellipse, and Shape descriptors were selected in a procedure of "Analyze" → "Set Measurement" which is one function of ImageJ. Next, a scale was set in order to determine a size for image quality. A scale-applied SEM image used for analysis was read and a line was drawn on a screen with the portion of the scale. Then, "Known distance": 10.00 was input in "Analyze" → "Set Scale" and $\mu$m was input in "Unit of length". Then, after the image was read and a process of "Image" → "Adjust" → "Threshold" was performed, a process of "Analyze" → "Analyze Particles" was performed, and the average circularity, the inclination angle of the long axis of the ellipsoidal shape, and the average length of the long axis of the ellipsoidal shape were calculated.

(2-3) Evaluation Method of Die Shear Strength

A shearing force was applied to the sample and evaluation of die shear strength was performed.
In order to remove foreign materials containing a porous copper layer in a side surface of the semiconductor element, the porous copper layer on an outer circumference of the mounted semiconductor element was removed and a sample for evaluating shear strength was obtained. When foreign materials containing a porous copper layer are contained in a side surface of the semiconductor element, a shear tool affects connection strength horizontally with respect to the side surface of the semiconductor element and measurement variation may be generated. Evaluation was performed using a shear test (device name: full-universal type bond tester series 4000 manufactured by Dage Japan). The shear tool was set to be 50 $\mu$m higher than an interface between the porous copper layer and a dense metal layer from a sample installation surface, a feed speed of the shear tool was set as 50 $\mu$m/sec, the semiconductor element was pressed horizontally, and a shear force was applied. In evaluation criteria, when a value which is obtained by dividing a measurement value of shear strength by the chip area was smaller than 50 MPa, this was determined as failure.
Hereinafter, Examples 1 to 9 and Comparative Examples 1 to 5 will be described.

[Examples 1 to 9]

The heat joining material was disposed between the substrate and the silicon chip using a sintering apparatus shown in Fig. 2 and sintering was performed under pressure.
The heat joining material was printed on the substrate using a metal mask having a thickness of 0.1 $\mu$m and including an opening area having a size of 8 mm x 8 mm and a squeegee. The printing was performed under conditions of a squeegee pressure of 1 MPa, a squeegee angle of 5 degrees, a squeegee speed of 5 mm/sec, and on-contact. Next, predrying of the printed heat joining material was performed at a temperature of 110°C under a nitrogen atmosphere using an oven. Then, the silicon chip was loaded on the printed portion and joining was performed by heating and sintering using the sintering apparatus. As shown in Table 1, the sintering was performed under a pressure of 10 MPa to 20 MPa at a sintering temperature of 300°C for a period of time for sintering of 20 minutes. After that, evaluation regarding the sintered sample was performed using the evaluation methods described above.

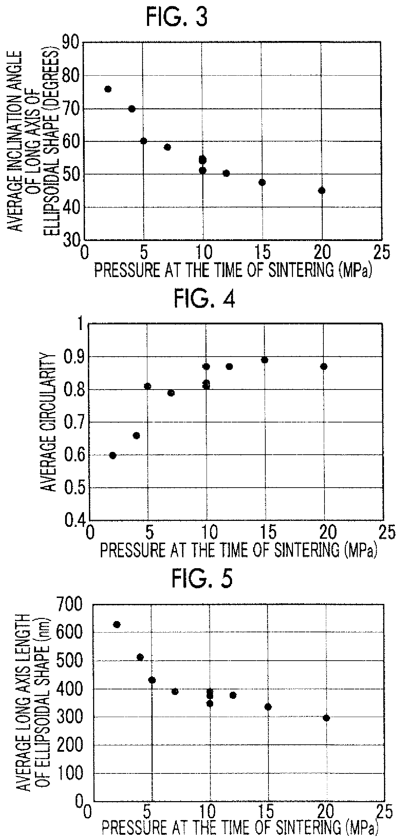

Fig. 12 shows a photographic image (5000 magnification) obtained by observing the cross section of the porous metal layer obtained in Example 8 using a scanning electron microscope (SEM). In image analysis, the binarization of a 5000-magnified photographic image shown in Fig. 12 was performed and a result thereof was analyzed. In this case, 567 ellipses were detected, the porosity was calculated as 2.1 (volume%), the average long axis length of the ellipsoidal shapes was calculated as 196 nm, and the average inclination angle of the ellipsoidal shape was calculated as 51.3°, and the average circularity was calculated as 0.82. All results of evaluation of Examples 1 to 9 are shown in Table 1 and Figs. 3 to 8.

The paste has suitable fluidity at the same time of pressurization at the time of sintering, and accordingly the paste flows in a horizontal direction (in-plane direction between the substrate and the chip) and the ellipsoidal shape is formed. As a method of applying fluidity to the paste, n-methylacetamide (NMA) was added to glycerin at a mass ratio of 1:9 and an organic dispersion medium was prepared in Examples and Comparative Examples.

[Comparative Examples 1 to 5]

The joining was performed by heating and sintering in the same manner as disclosed in Examples 1 to 9 except for performing sintering by changing only the pressure at the time of sintering to 2 MPa to 20 MPa, as shown in Table 2, and a connection structure was obtained.

All results of evaluation of Comparative Examples 1 to 5 are shown in Table 2 and Figs. 3 to 8.

[Table 1]

| | | Ex. 1 | Ex. 2 | Ex. 3 | Ex. 4 | Ex. 5 | Ex. | Ex. 7 | Ex. 8 | Ex. 9 |
|---|---|---|---|---|---|---|---|---|---|---|
| (1) Fine metal particle composition | | | | | | | | | | |
| Fine copper particle (P1) / fine copper particle (P2) | (mass ratio) | 5/5 | 5/5 | 5/5 | 5/5 | 4/6 | 3/7 | 2/8 | 5/5 | 5/5 |
| (1) Sintering conditions | | | | | | | | | | |
| Pressure at the time of sintering | (MPa) | 12 | 10 | 10 | 15 | 20 | 20 | 20 | 10 | 20 |
| (2) Results ot evaluation | | | | | | | | | | |
| Die shear strength | (MPa) | 52 | 63 | 58 | 69 | 38 | 33 | 24 | 65 | 74 |
| Porosity | (volume%) | 3.7 | 3.1 | 3.6 | 4.2 | 14.2 | 23.3 | 31.5 | 2.1 | 2.5 |
| Long axis length of ellipsoidal shapes | (nm) | 189 | 188 | 174 | 168 | 195 | 226 | 239 | 196 | 148 |
| Average circularity | (-) | 0.87 | 0.87 | 0.81 | 0.89 | 0.88 | 0.9 | 0.84 | 0.82 | 0.87 |
| Inclination angle of long axis of ellipsoidal shapes | (degree) | 50.3 | 54.1 | 54.8 | 47.6 | 46.3 | 44 | 45.6 | 51.3 | 45.2 |
| Number of usable times | (10000 times) | 9 | 5 | 3.7 | 11.8 | 12.7 | 12.2 | 6 | 6.2 | 13.2 |

[Table 2]

| | | Comparative Example 1 | Comparative Example 2 | Comparative Example 3 | Comparative Example 4 | Comparative Example 5 |
|---|---|---|---|---|---|---|
| (1) Fine metal particle composition | | | | | | |
| Fine copper particle (P1) /fine copper particle (P2) | (mass ratio) | 5/5 | 5/5 | 5/5 | 5/5 | 1/9 |

(continued)

|  |  | Comparative Example 1 | Comparative Example 2 | Comparative Example 3 | Comparative Example 4 | Comparative Example 5 |
|---|---|---|---|---|---|---|
| (1) sintering conditions |  |  |  |  |  |  |
| Pressure at the time of sintering | (MPa) | 5 | 7 | 2 | 4 | 20 |
| (2) Results of evaluation |  |  |  |  |  |  |
| Die shear strength | (MPa) | 55 | 59 | 28 | 36 | 18 |
| Porosity | (volume%) | 3.9 | 4.3 | 4.2 | 5.6 | 40.1 |
| Long axis length of ellipsoidal shapes | (nm) | 216 | 196 | 315 | 257 | 303 |
| Average circularity | (-) | 0.81 | 0.79 | 0.6 | 0.66 | 0.89 |
| Inclination angle of long axis of ellipsoidal shapes | (degree) | 60.3 | 58.4 | 76 | 70 | 44.5 |
| Number of usable limes | (10000 times) | 0.5 | 1.1 | 0.2 | 0.3 | 1.2 |

[Evaluation Results]

From Tables 1 to 2, plotting was performed in Figs. 3 to 5 by setting a horizontal axis as the pressure at the time of sintering and a vertical axis as the "inclination angle of long axis of ellipsoidal shape", "average circularity", and "average length of long axis of ellipsoidal shape". It was confirmed from Fig. 3 that as the pressure at the time of sintering increases, the "inclination angle of long axis of ellipsoidal shape" decreases. It was confirmed from Fig. 4 that as the pressure at the time of sintering increases, the average circularity increases. It was confirmed from Fig. 5 that as the pressure at the time of sintering increases, the "average length of long axis of ellipsoidal shape" decreases. It was confirmed from Figs. 3 to 5 that the "inclination angle of long axis of ellipsoidal shape", the "average circularity" and the "average length of long axis of ellipsoidal shape" can be controlled to some extent by adjusting the pressure at the time of sintering.

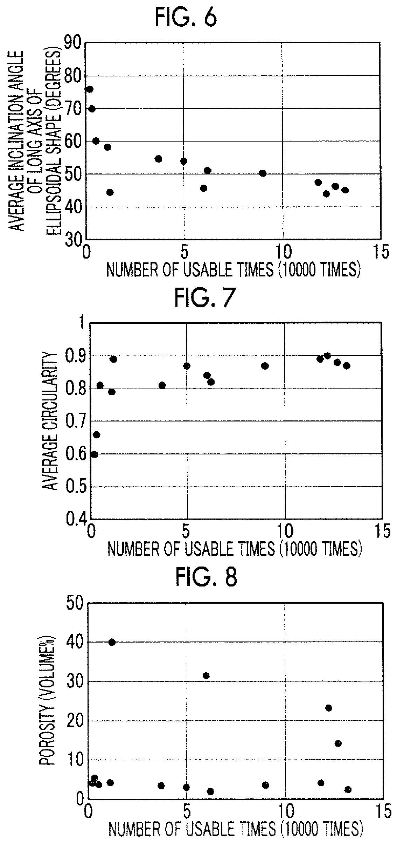

From Tables 1 to 2, plotting was performed in Figs. 6 to 8 by setting a horizontal axis as the "usable cycles" and a vertical axis as the "inclination angle of long axis of ellipsoidal shape", the "average circularity", and "porosity". It was confirmed from Fig. 8 that when the porosity is increased, reliability deteriorates. It was confirmed that as the "average circularity" increases, reliability becomes excellent, and as the inclination angle of long axis of ellipsoidal shape" decreases, reliability becomes excellent. When the porosity is smaller than 2 volume%, the sintered compact becomes close to a bulk body, and stress relaxation becomes poor. When the porosity is from 20% to 38%, it is possible to ensure strength when a die shear test for a sintered compact such as a reliability test (power cycle test) for a material in which mechanical strength of a chip and a sintered compact becomes slightly weak is performed. When the porosity exceeds 38%, the strength when a reliability test is performed cannot be ensured, and accordingly, it is necessary to adjust the porosity to be from 2 volume% to 38 volume%. It was confirmed that the semiconductor devices according to Examples 1 to 9 obtained by doing so have no peeling or voids between each layer or joining failures by using Scanning acoustic tomograph / inspection equipment.

[2] Examples 10 to 14 and Comparative Examples 6 and 7

Hereinafter, materials, evaluation methods, and examples used in Examples 10 to 14 and Comparative Examples 6 and 7 according to the second embodiment, and results of evaluation thereof will be described.

(1) Materials Used

(1-1) Preparation of Heat Joining Material

The same material as the heat joining material used in Example 8 described above was used.

(1-2) Substrates and Electronic Components

Substrates 1 and 2 and electronic components 1 to 5 used will be described later. The following substrates and electronic components respectively used in Examples 10 to 14 and Comparative Examples 6 and 7 are shown in Table 3.

(i) Substrates

As the substrate corresponding to the object to be connected (B) of the invention, the following substrate 1 and substrate 2 were used.
Substrate 1: a DBC substrate in which a copper circuit plate and a copper plate having a size of 28 mm x 28 mm were joined to each other on an inner side 1 mm apart from the outer periphery on a ceramic substrate having a size of 30 mm x 30 mm (Cu (0.3 mmt)/$Al_2O_3$ (0.635 mmt)/Cu (0.3 mmt) manufactured by NIPPON STEEL & SUMIKIN Electronics Devices Inc.) was used as the circuit board.
Substrate 2: a DBC substrate in which a copper circuit plate and a copper plate having a size of 28 mm x 28 mm were joined to each other on an inner side 1 mm apart from the outer periphery on a ceramic substrate having a size of 30 mm x 30 mm (Cu (0.3 mmt)/$Si_3N_4$ (0.32 mmt)/Cu (0.3 mmt) manufactured by Toshiba Materials Co., Ltd.) was used as the circuit board.

(ii) Electronic Components

The following electronic components 1 to 4 were used as the electronic component corresponding to the object to be connected (C) (conductive layer) of the invention.

Electronic component 1: copper foil having a size of 20 mm x 20 mm and a thickness of 0.3 nm

Electronic component 2: copper foil having a size of 28 mm x 28 mm and a thickness of 0.3 nm

Electronic component 3: copper foil having a size of 25 mm x 25 mm and a thickness of 0.3 nm

Electronic component 4: copper foil having a size of 15 mm x 15 mm and a thickness of 0.3 nm

[Table 3]

|  | Example 10 | Example 11 | Example 12 | Example 13 | Example 14 | Comparative Example 6 | Comparative Example 7 |
|---|---|---|---|---|---|---|---|
| Substrate used | Substrate 1 | Substrate 1 | Substrate 2 | Substrate 1 | Substrate 1 | Substrate 1 | Substrate 1 |
| Electronic component used | Electronic component 1 | Electronic component 2 | Electronic component 1 | Electronic component 3 | Electronic component 4 | Electronic component 1 | None |

(2) Mounting Method

[Examples 10 to 14]

The substrates and the electronic components shown in Table 3 were prepared.

A metal mask including an opening area having the same size as that of the electronic components 1 to 5 and having a thickness of 100 $\mu$m was prepared. Printing was performed using the metal mask and the squeegee corresponding to the electronic component mounted on the substrates 1 and 2 using this metal mask. Then, the material was dried in an oven at 110°C in the atmosphere for 30 minutes, in order to evaporate the organic dispersion medium in the paste. The joining was performed by the same method as disclosed in Example 8. The joining conditions were set as a temperature of 300°C, a pressure of 10 MPa, and a period of time of 20 minutes. The atmosphere was an atmosphere at a reduced pressure. In addition, Teflon was used as the additional material 15. The same sample as that created in Example 10 was created as a sample for observation, in order to observe the shape of the cross section of the sintered compact. A working method and an observation method of the sample were as the methods disclosed in Example 8.

The results of the observations were that the porosity was 3.3%, the average length of the long axis of the ellipsoidal shape was 182 nm, and the average circularity was 0.84, and the inclination angle of the long axis of the ellipsoidal shape was 52.3 (degrees). These values are the same as those in Examples 8.

[Comparative Example 6]

A member to be used in Comparative Example 6 was prepared. The substrate and the electronic component shown in Table 3 are prepared, brazing filler metal formed of 71.0 mass% of Ag, 16.5 mass% of Cu, and 2.5 mass% of Ti was applied on the copper circuit plate to have a thickness of 30 $\mu$m, the electronic component is mounted, and heating and joining were performed in a vacuum furnace. The mounting of the semiconductor element and the connection performed by the wire bonding after that were performed in the same manner as in Example 1.

[Comparative Example 7]

In Comparative Example 7, the joining was performed using solder which will be described later, without performing the joining to the object to be connected (C) (conductive layer).

(3) Evaluation Methods

(3-1) Evaluation of Cracks and Peeling Between Layers

Regarding each of 20 (n = 20) semiconductor packages in Examples 10 to 14 and Comparative Example 6 and 7, a heat cycle test in which a cycle of holding the semiconductor package at -40°C for 30 minutes and increasing the temperature to 150°C and the holding semiconductor package for 30 minutes, was performed. After that, presence or absence of cracks on the substrate and peeling between layers were observed and evaluated using Scanning acoustic tomograph / inspection equipment. Results thereof are shown in Table 4.

The number of cycles (n) after which peeling or cracks are observed in 10% of the area of the sintered compact layer which is a joined part is confirmed by a supersonic detector, and the average number of cycles for a sample in which peeling or cracks are observed with a number of cycles of less than 2000, is shown. The numbers in parentheses show the number of samples in which peeling or cracks were observed. In addition, "-" was noted for samples in which peeling or cracks were not observed with a number of cycles of 2000.

(3-2) Mounting Method of Semiconductor Chip for Heat Generation

In Examples 10 to 14 and Comparative Example 6, a semiconductor chip for heat generation was first joined to an upper portion of the manufactured electronic component, in order to perform evaluation. In the joining method, copper nano paste which was the same as the porous metal layer and was used in Example 8 was printed on the upper portion of the electronic component in the same conditions using the metal mask including an opening area having a size of 5 mm x 5 mm, and dried under the same conditions as in Example 8, the semiconductor element was mounted thereon, and pressurized and heated under the same conditions as in Example 8, and joining was performed. After that, a terminal formed on the upper portion of the semiconductor element and the wiring of the circuit board were connected to each other by wire bonding. As the semiconductor element, an element having an area of 5 mm x 5 mm and a thickness of 0.23 mm was used.

In Comparative Example 7, a necessary DBC substrate was prepared, a Sn-0.1 Ag-0.7 Cu solder layer was formed at a position corresponding to a position for mounting the semiconductor element on the copper circuit plate, and the semiconductor element was loaded on the solder layer, heated at 240°C under a nitrogen atmosphere for 0.5 minutes, and joined. Then, a terminal formed on the upper portion of the semiconductor element and the wiring of the circuit board were connected to each other by wire bonding. As the semiconductor element, an element having an area of 5 mm x 5 mm and a thickness of 0.23 mm was used.

(3-3) Evaluation Method of Heat Radiation

The same method as disclosed in Example 8 was performed.

Regarding each of 20 semiconductor packages according to Examples 10 to 14 and Comparative Examples 6 and 7, current flows to the semiconductor element such that a heat input became 100 W, and a temperature rise in the upper surface of the semiconductor element were measured.

Evaluation criteria were as follows.

A: Average increased temperature was equal to or lower than 175°C. Effect of heat radiation was particularly excellent.
B: Average increased temperature exceeded 175°C and was equal to or lower than 200°C. Effect of heat radiation was excellent.
C: Average increased temperature exceeded 200°C. Effect of heat radiation was poor.

[Results of Evaluation]

Results are shown in Table 4.

In Examples 10 to 14, the sintered compact layer formed of the sintered compact of metal particles was formed on the metal circuit layer and the conductive layer was formed on the sintered compact layer, and accordingly cracks or peeling between layers were excellently prevented and effects of heat radiation were also excellent.

In Comparative Example 6, the metal circuit layer and the conductive layer were joined to each other by brazing filler metal and the thermal conductivity between the metal circuit layer and the conductive layer was not high, heat radiation was worse than that of Example 10. In addition, peeling occurred on a joined surface between the metal circuit layer and the conductive layer due to a difference in linear expansion between the brazing filler metal, the metal circuit layer, and the conductive layer. After an average of 700 cycles, cracks were generated and peeling occurred in all samples, and accordingly, durability of the ceramic substrate and the metal circuit layer could not be confirmed. In Comparative Example 7, since the semiconductor element was directly connected to the metal circuit layer using solder, peeling between layers or the like did not occur, but the connection was performed without using the conductive layer, and accordingly, a heat capacity of the metal circuit layer was small with respect to heat from the semiconductor element which was a heat source, thus, heat radiation properties were significantly poor.

As described above, in Examples 10 to 14 in which the porous metal layer formed of the sintered compact of fine metal particles was formed on the metal circuit layer and the conductive layer was formed on the porous metal layer, it was possible to realize excellent heat radiation properties and prevention of peeling on the joined surface which were not realized in Comparative Examples 6 and 7. Particularly, in Examples 10 and 12, cracks between the metal circuit layer and the conductive layer and between the ceramic substrate and the metal circuit layer or peeling between layers were effectively prevented and heat radiation properties were also excellent. In addition, as found from Example 12, it was possible to more effectively realize prevention of cracks between the ceramic substrate and the metal circuit layer and high heat radiation properties, by using ceramic having high fracture toughness such as $Si_3N_4$ as the ceramic substrate.

As described above, regarding a semiconductor element in which heat generation at the time of driving is significant, when high frequency and heavy current operation is performed, such as in a power semiconductor element, it is necessary to decrease heat resistance of a layer disposed on the side below the semiconductor element, for instantly releasing heat. Accordingly, a technology for increasing a heat capacity of the metal circuit layer by increasing an area or a thickness of the metal circuit layer has been proposed (for example, JP-A-2003-188316).

However, when an area or a thickness of the metal circuit layer is increased, a difference between a coefficient of linear expansion of the ceramic substrate and a coefficient of linear expansion of the metal circuit layer is great, when a temperature cycle in which the materials are left under a low temperature environment and then left in a high temperature environment, in a manufacturing stage, and accordingly, the ceramic substrate may break along the interface of the metal circuit layer.

There is a technology (for example, Japanese Patent No. 3932343) for forming a difference in level on the end portion of the metal circuit layer by etching, but with such a technology, it is difficult to form a shape or a height of a difference in level on the end portion of the metal circuit layer with excellent accuracy. In a technology (for example, JP-A-2000-311969) for providing a high-melting-point metal layer which is mainly formed of a high-melting-point metal and a metal interposition layer which has a melting point equal to or lower than 1000°C and includes at least one kind of nickel, copper, iron as a main component, on a ceramic substrate and joining a conductive layer including copper as a main substance onto the metal interposition layer, the metal interposition layer is substantially formed by plating and linear expansion locally varies because the high-melting-point metal layer or the conductive layer subjected to plating has a slightly bulky shape, and accordingly, peeling may occur in the metal interposition layer and reliability may be decreased.

From the description above, particularly, in a semiconductor device in which there is generation of heat, it is preferable to use a structure including the metal circuit layer which is formed on one surface side of the ceramic substrate, the porous metal layer (ii) which is formed on the metal circuit layer and formed of the sintered compact of the fine metal particles (P), the conductive layer (iii) which is formed on the porous metal layer (ii), and the semiconductor element (v) which is joined to the conductive layer by the die-bonding joining layer (iv), and it being thus possible to improve heat radiation. Particularly, it is possible to prevent cracks or peeling between the metal circuit layer and the conductive layer (iii) and realize a semiconductor device having high reliability.

[Table 4]

| | wiring board | Connection structure | Conductive layer | Copper circuit plate area | Conductive layer area | Proportion of conductive layer area | Peeling cracks durability number [n=20] | | | Heating characteristics |
|---|---|---|---|---|---|---|---|---|---|---|
| | | | | | | | Ceramic substrate,-metal circuit layer | Metal circuit layer-conductive layer | 2000 cycles durability number | |
| Ex. 10 | $Cu/Al_2O_3/Cu$ | Sintered compact layer | Cu | 28 mm × 28 mm | 20 mcn × 20 mm | 71% | 1900(n=1) | - | n=1 | A |
| Ex. 11 | $Cu/Al_2O_3/Cu$ | Sintered compact layer | Cu | 28 mm × 28 mm | 28 mm × 28 mm | 100% | 1700 (n=4) | 1800 (n=11) | n=15 | A |
| Ex. 12 | $Cu/Si_3N_4/Cu$ | Sintered compact layer | Cu | 28 mm × 28 mm | 20 mm × 20 mm | 71% | - | - | n=0 | A |
| Ex. 13 | $Cu/Al_2O_3/Cu$ | Sintered compact layer | Cu | 28 mm × 28 mm | 25 mm × 25 mm | 89% | 1800 (n=2) | 1900 (n=16) | n=18 | A |
| Ex. 14 | $Cu/Al_2O_3/Cu$ | Sintered compact layer | Cu | 28 mm × 28 mm | 15 mm × 15 mm | 54% | - | - | n=0 | B |
| Com. Ex. 6 | $Cu/Al_2O_3/Cu$ | brazing filler metal | Cu | 28 mm × 28 mm | 20 mm × 20 mm | 71% | - | 700 (n=20) | n=20 | B |
| Com. Ex. 7 | $Cu/Al_2O_3/Cu$ | - | - | 28 mm × 28 mm | - | - | - | - | n=0 | C |

Reference Signs List

1 Semiconductor device
2 Ceramic substrate
3 Metal circuit layer (corresponding to object to be connected (B) of first embodiment)
4 Metal layer
5 Circuit board (i)
6 Die-bonding joining layer (iv)
7 Conductive layer (iii) (corresponding to object to be connected (C) of first embodiment)
8 Porous metal layer (ii) (corresponding to porous metal layer (A) of first embodiment)
9 Semiconductor element (v)
21 Metal portion
22 Hole (h)
23 Normal to thickness direction of porous metal layer (A)
24 Inclination angle of long axis of ellipsoidal shape of hole (h) with respect to normal to thickness direction of porous metal layer (A)
25 Long axis length of ellipsoidal shape of hole (h)
41 Workpiece
42 Pressing plate
43 Vacuum pressing machine
44 Lower heating platen
45 Chamber
46 Pressurizing cylinder
47 Upper heating platen

**Claims**

1. A connection structure in which a object to be connected (C) is joined onto a object to be connected (B) by a porous metal layer (A) which is a connector,
   wherein a porosity of the porous metal layer (A) is from 2 volume% to 38 volume%,
   the porous metal layer (A) includes an approximately ellipsoidal hole (h), an average circularity of an ellipsoidal shape of the hole (h) in a cross section (V) of the porous metal layer (A) in a thickness direction is from 0.80 to 0.90,
   an average value of inclination angles of a long axis of an ellipsoidal shape of the hole (h) with respect to the normal to the thickness direction of the cross section (V) is equal to or smaller than 57 degrees, and
   an average long axis length of the ellipsoidal shape of the hole (h) in the cross section (V) is from 30 nm to 500 nm.

2. The connection structure according to claim 1,
   wherein an average value of inclination angles of the long axis of the ellipsoidal shape of the hole (h) with respect to the normal to the thickness direction of the cross section (V) is from 50 degrees to 57 degrees.

3. The connection structure according to claim 1 or 2,
   wherein a metal forming the porous metal layer (A) is one kind or two or more kinds selected from gold, silver, copper, aluminum, chromium, nickel, titanium, cobalt, and indium.

4. The connection structure according to any one of claims 1 to 3,
   wherein a joined surface part of the object to be connected (B) and the object to be connected (C) with the porous metal layer (A) is formed of one kind or an alloy including two or more kinds selected from gold, silver, copper, chromium, nickel, and titanium.

5. The connection structure according to any one of claims 1 to 4,
   wherein at least a part of the holes (h) formed on the porous metal layer (A) is filled with a heat-resistant resin (R).

6. A semiconductor device which has a structure in which a circuit board (i) formed of at least a ceramic substrate and a metal circuit formed thereon, a porous metal layer (ii), a conductive layer (iii), a die-bonding joining layer (iv), and a semiconductor element (v) are laminated on each other in this order,

wherein a porosity of the porous metal layer (ii) is from 2 volume% to 38 volume%,
the porous metal layer (ii) includes an approximately ellipsoidal hole (h), an average circularity of an ellipsoidal shape of the hole (h) in a cross section (V) of the porous metal layer (ii) in a thickness direction is from 0.80 to 0.90, an average value of inclination angles of a long axis of an ellipsoidal shape of the hole (h) with respect to the normal to thickness direction of the to the cross section (V) is equal to or smaller than 57 degrees, and an average long axis length of the ellipsoidal shape of the hole (h) in the cross section (V) is from 30 nm to 500 nm.

FIG. 1

## FIG. 2A

## FIG. 2B

## FIG. 2C

## FIG. 3

## FIG. 4

## FIG. 5

# FIG. 6

# FIG. 7

# FIG. 8

FIG. 9

FIG. 10A

FIG. 10B

FIG. 10C

FIG. 11A

FIG. 11B

FIG. 12

## INTERNATIONAL SEARCH REPORT

| International application No. |
| --- |
| PCT/JP2014/067050 |

| A. CLASSIFICATION OF SUBJECT MATTER |
| --- |
| *H01L21/52*(2006.01)i |

According to International Patent Classification (IPC) or to both national classification and IPC

| B. FIELDS SEARCHED |
| --- |
| Minimum documentation searched (classification system followed by classification symbols)<br>H01L21/52 |

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | WO 2011/114751 A1  (The Furukawa Electric Co., Ltd.),<br>22 September 2011 (22.09.2011),<br>paragraphs [0008] to [0013]<br>& JP 5158904 B          & US 2013/0001775 A1<br>& EP 2560197 A1          & CN 102812543 A<br>& KR 10-2013-0053400 A | 1-6 |
| A | JP 2009-515711 A  (Intel Corp.),<br>16 April 2009 (16.04.2009),<br>paragraphs [0018] to [0042]; fig. 1 to 4<br>& JP 5091873 B          & US 2007/0152016 A1<br>& WO 2007/078717 A2      & KR 10-2008-0083127 A<br>& CN 101351295 A          & TWB 00I358340 | 1-6 |

☐ Further documents are listed in the continuation of Box C.    ☐ See patent family annex.

| | |
| --- | --- |
| * Special categories of cited documents:<br>"A" document defining the general state of the art which is not considered    to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 12 September, 2014 (12.09.14) | 22 September, 2014 (22.09.14) |

| Name and mailing address of the ISA/<br>Japanese Patent Office | Authorized officer |
| --- | --- |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004128357 A
- JP 2000094341 A
- JP 2013041895 A
- JP 2003188316 A
- JP 3932343 B
- JP 2000311969 A